# EUROPÄISCHE PATENTSCHRIFT

(11) **EP 2 227 844 B1**
(45) Veröffentlichungstag und Bekanntmachung des Hinweises auf die Patenterteilung: **12.03.2014**
(21) Anmeldenummer: 08865054.4
(22) Anmeldetag: 10.12.2008
(51) Int. Cl.: H01S 5/02, H01S 5/042, H01S 5/10, H01S 5/04, H01S 5/183, H01S 5/40, H01S 5/026

(54) **OBERFLÄCHENEMITTIERENDER HALBLEITERLASER UND VERFAHREN ZU DESSEN HERSTELLUNG**
SURFACE-EMITTING SEMICONDUCTOR LASER AND METHOD FOR PRODUCING THE SAME
LASER À SEMI-CONDUCTEUR À ÉMISSION PAR LA SURFACE ET PROCÉDÉ POUR SA PRODUCTION

(30) Priorität: 21.12.2007 DE 102007062128; 12.02.2008 DE 102008008595
(43) Veröffentlichungstag der Anmeldung: 15.09.2010
(73) Patentinhaber: Osram Opto Semiconductors Gmbh, 93055 Regensburg (DE)
(72) Erfinder: ILLEK, Stefan, 93093 Donaustauf (DE)
(74) Vertreter: Epping - Hermann - Fischer
(86) Internationale Anmeldenummer: PCT/DE2008/002068
(87) Internationale Veröffentlichungsnummer: WO 2009/079986

(56) Entgegenhaltungen:
- WO-A-98/31080
- DE-A1-102006 024 220
- US-A- 5 796 771
- US-A1- 2007 217 463

## Beschreibung

Die Erfindung betrifft einen oberflächenemittierenden Halbleiterlaser mit einem Vertikalemitter, einem Pumplaser und einem Trägerkörper gemäß Patentanspruch 1. Weiterhin betrifft die Erfindung ein Verfahren zum Herstellen eines solchen oberflächenemittierenden Halbleiterlasers gemäß Patentanspruch 11.

Diese Patentanmeldung beansprucht die Prioritäten der deutschen Patentanmeldung 10 2007 062 128.2 und der deutschen Patentanmeldung 10 2008 008 595.2.

Bei herkömmlichen oberflächenemittierenden Halbleiterlasern, die einen optisch gepumpten Vertikalemitter und einen integrierten Pumplaser zum optischen Pumpen des Vertikalemitters aufweisen, kann zur Verbesserung der Wärmeabfuhr die erzeugte Strahlung substrat-seitig ausgekoppelt werden ("bottom emitter"). Bei der Herstellung der epitaktischen Schichtfolge wird hierbei der Pumplaser auf einem Substrat und der Vertikalemitter auf der dem Substrat abgewandten Seite des Pumplasers angeordnet. Zur thermischen Ankopplung wird auf der dem Substrat abgewandten Seite des Vertikalemitters eine galvanische Schicht, die beispielsweise Gold enthält, aufgebracht und anschließend planarisiert.

Ein optoelektronisches Bauelement, das einen Halbleiterkörper mit einem Vertikalemitterbereich und einer monolithisch integrierten Pumpquelle aufweist, ist beispielsweise aus der DE 10 2006 024 220 A1 bekannt.

Ein Verfahren zur Herstellung von Halbleiterchips, die eine galvanisch aufgebrachte Verstärkungsschicht bestehend aus Gold aufweisen, ist beispielsweise aus der Druckschrift DE 100 40 448 A1 bekannt. Dabei wird eine aktive Schicht auf ein Substrat aufgewachsen. Auf der aktiven Schicht werden rückseitige Kontaktschichten ausgebildet, auf die mittels Galvanik eine Goldschicht aufgebracht wird; Nach dem Aufbringen einer Hilfsträgerschicht auf die Verstärkungsschicht auf galvanischem Wege wird das Substrat von der aktiven Schicht getrennt.

Die galvanisch hergestellte Schicht kann zu starken Verspannungen führen, wodurch eine weitere Prozessierung beeinträchtigt wird. Ferner können Verspannungen zu Schäden innerhalb eines Halbleiterlasers und dadurch zu einer geringeren Lebensdauer führen.

Ferner können starke Verspannungen die Herstellung des oberlächenemittierenden Halbleiterlasers erschweren. Beispielsweise erschweren Verspannungen, die durch die galvanische Schicht auftreten können, die Prozessierung mehrerer Halbleiterlaser auf einem gemeinsamen Trägerkörper oder Wafer, der eine Größe von 100 mm und mehr aufweist, also die Herstellung von Halbleiterlasern im Waferverbund für die Herstellung in Großserie. Beispielsweise können Verspannungen in den Schichten im Waferverbund zu Verbiegungen oder Rissen im Wafer führen, die einer weiteren Prozessierung des Waferverbunds entgegenstehen.

Ferner ist es bei herkömmlichen oberflächenemittierenden Halbleiterlasern, die die erzeugte Strahlung substrat-seitig auskoppeln, erforderlich, zur Strahlungsauskopplung eine Lichtaustrittsöffnung in das Substrat zu ätzen.

Der Erfindung liegt die Aufgabe zugrunde, einen oberflächenemittierenden Halbleiterlaser mit einer erhöhten Langzeitstabilität, insbesondere mit einer erhöhten Lebensdauer anzugeben. Ferner liegt der Erfindung die Aufgabe zugrunde, einen oberflächenemittierenden Halbleiterlaser mit einer vereinfachten Prozessführung anzugeben, der sich insbesondere durch reduzierte Produktionskosten und eine reduzierte Produktionszeit auszeichnet.

Diese Aufgabe wird durch einen oberflächenemittierenden Halbleiterlaser mit den Merkmalen des Patentanspruchs 1 und ein Verfahren zu dessen Herstellung mit den Merkmalen des Patentanspruchs 11 gelöst. Vorteilhafte Ausführungsformen und bevorzugte Weiterbildungen des Halbleiterlasers sind Gegenstände der abhängigen Ansprüche.

Erfindungsgemäß ist ein oberflächenemittierender Halbleiterlaser vorgesehen, der eine erste Halbleiterschichtenfolge, die einen Pumplaser umfasst, und eine auf der ersten Halbleiterschichtenfolge angeordnete zweite Halbleiterschichtenfolge, die einen Vertikalemitter umfasst, aufweist. Der Vertikalemitter weist eine strahlungsemittierende aktive Schicht, eine Strahlungsaustrittsseite und eine der Strahlungsaustrittsseite gegenüberliegende Befestigungsseite auf. An der Strahlungsaustrittsseite des Vertikalemitters ist der Pumplaser angeordnet. Die Auskopplung der von der aktiven Schicht im Betrieb erzeugten Strahlung erfolgt somit durch den Pumplaser hindurch. An der Befestigungsseite des Vertikalemitters ist der Trägerkörper angeordnet.

Zur mechanischen Stabilisierung des Halbleiterlasers ist somit kein Substrat vorgesehen, auf das der Pumplaser und der Vertikalemitter angeordnet sind, sondern ein Trägerkörper, der auf der Strahlungsaustrittsseite gegenüberliegenden Seite des Vertikalemitters angeordnet ist. Eine galvanische Schicht, die beispielsweise Gold enthält und auf der dem Substrat abgewandten Seite des Vertikalemitters aufgebracht ist, findet somit keine Verwendung. Verspannungen, die durch die galvanische Schicht auftreten können, entstehen dadurch nicht. Insgesamt erhöhen sich somit mit Vorteil die Langzeitstabilität des Halbleiterlasers, sowie die Lebensdauer. Ferner ermöglicht sich dadurch eine weitere Prozessierung des Halbleiterlasers, da die in dem Halbleiterlaser auftretenden Verspannungen verringert vorliegen.

Ferner ist ein Aufwachssubstrat, auf dem die erste und die zweite Halbleiterschichtenfolge aufgewachsen wurden, abgelöst. Somit ist es nicht notwendig, eine Lichtaustrittsöffnung für die von dem Vertikalemitter emittierte Strahlung in das Aufwachssubstrat zu ätzen. Eine vereinfachte Herstellung, und somit reduzierte Produktionskosten und eine reduzierte Produktionszeit des oberflächenemittierenden Halbleiterlasers sind mit Vorteil möglich.

Der oberflächenemittierende Halbleiterlaser ist als Dünnfilm-Halbleiterlaser ausgeführt. Als Dünnfilm-Halbleiterlaser wird im Rahmen der Anmeldung ein Halbleiterlaser angesehen, während dessen Herstellung das Aufwachssubstrat, auf den eine erste und eine zweite Halbleiterschichtenfolge beispielsweise epitaktisch aufgewachsen wurde, abgelöst ist.

Ein Grundprinzip eines Dünnfilm-Chips ist beispielsweise in I. Schnitzer et al., Appl. Phys. Lett. 63 (16), 18. Oktober 1993, 2174 - 2176 beschrieben.

Der Halbleiterlaser umfasst ferner einen Trägerkörper, der den Vertikalemitter und den Pumplaser mechanisch stabilisiert und besonders bevorzugt von dem Aufwachssubstrat für die erste und die zweite Halbleiterschichtenfolge des Halbleiterlasers verschieden ist.

Der Trägerkörper des Dünnfilm-Halbleiterlasers unterliegt mit Vorteil nicht den vergleichsweise hohen Anforderungen, die ein Aufwachssubstrat, etwa hinsichtlich der Kristallstruktur oder des Ausdehnungskoeffizienten, erfüllen muss. Die Freiheitsgrade bei der Auswahl des Trägerkörpers sind gegenüber den Freiheitsgraden bei der Auswahl des Aufwachssubstrats vorteilhaft erhöht. Beispielsweise kann der Trägerkörper hinsichtlich thermischer Eigenschaften, wie einen an die Halbleiterschichtenfolge angepassten thermischen Ausdehnungskoeffizienten oder einer hohen Wärmeleitfähigkeit, vergleichsweise frei gewählt werden. Eine hohe Wärmeleitfähigkeit ist bei Anwendungen, bei denen im Betrieb des Halbleiterlasers im Vertikalemitter eine maßgebliche Wärmemenge erzeugt wird, von besonderer Bedeutung. Wird die im Vertikalemitter erzeugte Wärmemenge nicht ausreichend vom Vertikalemitter abgeführt, so ist die Gefahr einer Schädigung des Vertikalemitters erhöht. Ferner nimmt bei zu hohen Temperaturen die Effizienz des Vertikalemitters stark ab. Durch den Einsatz eines vom Aufwachssubstrat verschiedenen Trägerkörpers mit bevorzugt hoher Wärmeleitfähigkeit kann diese Gefahr mit Vorteil verringert werden.

Die erste und die zweite Halbleiterschichtenfolge basieren bevorzugt auf einem Arsenid-, Phosphid oder einem Nitrid-Verbindungshalbleiter. "Auf Arsenid-, Phosphid- oder Nitrid-Verbindungshalbleitern basierend" bedeutet in diesem Zusammenhang, dass ein derart bezeichneter Halbleiterlaser oder Teil eines Halbleiterlasers vorzugsweise AlₙGaₘIn₁₋ₙ₋ₘAs, AlₙGaₘIn₁₋ₙ₋ₘP oder AlₙGaₘIn₁₋ₙ₋ₘN umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es einen oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, P, As, N), auch wenn diese teilweise durch geringe Mengen weiterer Stoffe ersetzt sein können.

Bevorzugt emittiert die aktive Schicht des Vertikalemitters infrarote Strahlung.

Die aktive Schicht des Vertikalemitters umfasst bevorzugt eine Mehrfachquantentopfstruktur (MQW) oder eine Einfachquantentopfstruktur (SQW) zur Strahlungserzeugung. Die Bezeichnung Quantentopfstruktur umfasst im Rahmen der Anmeldung insbesondere jegliche Struktur, bei der Ladungsträger durch Einschluss ("confinement") eine Quantisierung ihrer Energiezustände erfahren können. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

Der Vertikalemitter wird von dem Pumplaser optisch gepumpt. Dabei ist die Wellenlänge der optischen Pumpstrahlung bevorzugt kleiner als die Wellenlänge der von der aktiven Schicht des Vertikalemitters emittierten Strahlung. Der Pumplaser weist einen Resonator für die Pumpstrahlung auf. Dazu sind zum Beispiel an zwei parallel zueinander liegenden Endflächen des Pumplasers Spiegelflächen ausgebildet, die als Resonatorspiegel dienen. Diese können beispielsweise durch Ätzen (beispielsweise Trockenätzen) erzeugt und hoch reflektierend verspiegelt sein.

Bevorzugt besitzt die Pumplaserstruktur eine aktive Zone, die zwischen einer ersten und einer zweiten Wellenleiterschicht eingebettet ist, wobei die Wellenleiterschichten wiederum zwischen einer ersten und einer zweiten Mantelschicht eingebettet sind.

Der Vertikalemitter ist bevorzugt auf Bereichen des Pumplasers angeordnet. Die aktive Schicht des Vertikalemitters ist hierbei an die Pumplaserstruktur optisch gekoppelt, sodass im Betrieb des Halbleiterlasers Pumpstrahlung von dem Pumplaser in die aktive Schicht des Vertikalemitters geführt wird.

Ein Prinzip zur Einkopplung der Pumpstrahlung in die aktive Schicht des Vertikalemitters ist beispielsweise aus der Druckschrift WO 2005/048423 A1 bekannt.

Um die Einkopplung von Pumpstrahlung in den Vertikalemitter zu verbessern, ist vorteilhafterweise der Brechungsindex der einen Wellenleiterschicht des Pumplasers größer als der Brechungsindex der zweiten Wellenleiterschicht des Pumplasers und/oder ist die aktive Zone des Pumplasers asymmetrisch in dem von den beiden Wellenleiterschichten ausgebildeten Wellenleiter platziert.

Denkbar ist ferner ein Pumplaser zum optischen Pumpen der aktiven Schicht des Vertikalemitters, bei dem der Pumplaser eine kantenemittierende Halbleiterstruktur aufweist. In diesem Fall ist der kantenemittierende Pumplaser derart angeordnet, daß die Pumpstrahlung aus seitlicher Richtung in die aktive Schicht des Vertikalemitters eingestrahlt wird. Insbesondere sind die aktive Schicht des Vertikalemitters und der Pumplaser vorzugsweise derart lateral nebeneinander angeordnet, dass die aktive Zone des Pumplasers und die aktive Schicht des Vertikalemitters auf gleicher Höhe liegen.

Bei einer bevorzugten Ausgestaltung des Halbleiterlasers weist die zweite Halbleiterschichtenfolge einen strahlungsemittierenden Bereich auf, der die strahlungsemittierende aktive Schicht umfasst und durch optisches Pumpen des Pumplasers im Betrieb Strahlung emittiert. Ferner weist die zweite Halbleiterschichtenfolge mindestens einen Bereich auf, der im Betrieb keine Strahlung emittiert.

Es wird also nicht, wie herkömmlich, die gesamte zweite Halbleiterschichtenfolge außerhalb des vorgesehenen strahlungsemittierenden Bereichs entfernt. Es werden mit Vorteil nur die Bereiche entfernt, beispielsweise durch Tieferätzen, bei denen bei nachfolgenden Prozessschritten auf die erste Halbleiterschichtenfolge zugegriffen werden muss. Als nachfolgende Prozesse können beispielsweise Spiegelätzung der Resonatorspiegel des Pumplasers und/oder die elektrische Kontaktierung des Pumplasers angesehen werden.

Bei einer bevorzugten Ausgestaltung weist die erste Halbleiterschichtenfolge sowohl einen Bereich auf, der Pumpstrahlung erzeugt als auch mindestens einen Bereich auf, der im Betrieb keine Pumpstrahlung erzeugt.

Besonders bevorzugt sind auf den Bereichen der ersten Halbleiterschichtenfolge, die im Betrieb keine Pumpstrahlung erzeugen, die Bereiche der zweiten Halbleiterschichtenfolge aufgebracht, die im Betrieb keine Strahlung emittieren.

Dadurch erhöht sich die mechanische Stabilität des Halbleiterlasers mit Vorteil, da sowohl die erste als auch die zweite Halbleiterschichtenfolge großflächig, nämlich bis auf die Bereiche, die für die nachfolgende Prozessierung zugängig sein müssen, ausgebildet sind.

Bei einer weiteren Ausgestaltung weist der Pumplaser auf einer dem Vertikalemitter zugewandten Seite auf Bereichen, auf denen die zweite Halbleiterschichtenfolge entfernt ist, eine erste Kontaktschicht auf. Die erste Kontaktschicht dient zur elektrischen Kontaktierung des Pumplasers.

Bei einer bevorzugten Ausgestaltung weist die erste Halbleiterschichtenfolge auf einer dem Vertikalemitter abgewandten Oberfläche eine Ätzstoppschicht auf.

Die Ätzstoppschicht schützt den Pumplaser vor Schäden, die bei dem Ablösen des Aufwachssübstrats durch einen Ätzprozess entstehen können.

Bevorzugt ist eine zweite Kontaktschicht auf eine von dem Pumplaser abgewandte Oberfläche der Ätzstoppschicht aufgebracht, die in einem dem Vertikalemitter gegenüberliegenden Bereich eine Aussparung aufweist. Die zweite Kontaktschicht und die erste Kontaktschicht dienen zur gemeinsamen elektrischen Kontaktierung des Pumplasers. Die Aussparung der zweiten Kontaktschicht in einem dem Vertikalemitter gegenüberliegenden Bereich dient zur Strahlungsauskopplung der von der aktiven Schicht des Vertikalemitters emittierten Strahlung.

Alternativ kann die zweite Kontaktschicht auf der dem Vertikalemitter abgewandten Oberfläche des Pumplasers aufgebracht sein. In diesem Fall dient die zweite Kontaktschicht zusätzlich als Ätzstoppschicht. Eine zusätzliche Ätzstoppschicht zwischen Pumplaser und zweiter Kontaktschicht ist mit Vorteil nicht notwendig.

Die zweite Halbleiterschichtenfolge ist bevorzugt an dem Trägerkörper befestigt. Dabei kann die zweite Halbleiterschichtenfolge beispielsweise mittels einer Lotschicht, einer Klebeschicht oder einer Thermö-Kompression an dem Trägerkörper befestigt sein.

Dadurch ist es nicht, wie herkömmlicherweise, notwendig, eine galvanische Schicht auf den Vertikalemitter aufzubringen, die nachteilig zu Verspannungen in dem Halbleiterlaser führen kann. Dadurch erhöhen sich die mechanische Stabilität und gleichzeitig die Lebensdauer des Halbleiterlasers mit Vorteil.

Bevorzugt weist der Vertikalemitter auf der dem Pumplaser abgewandten Seite einen Spiegel auf. Besonders bevorzugt weist der Vertikalemitter auf der dem Pumplaser abgewandten Seite einen Bragg-Spiegel auf.

Dadurch, dass der Bragg-Spiegel an der dem Pumplaser abgewandten Seite angeordnet ist, muss die Stromzuführung für den Pumplaser nicht über den Bragg-Spiegel erfolgen. Dadurch lassen sich Dotierungen im Bragg-Spiegel vermeiden, die zu einer verminderten Reflektivität des Bragg-Spiegels und somit zu optischen Verlusten führen können. Dadurch ergibt sich eine verminderte Absorption der von dem Vertikalemitter emittierten Strahlung.

Bevorzugt werden mehrere Halbleiterlaser im Waferverbund, also auf einem gemeinsamen Trägerkörper oder Wafer, prozessiert. Dadurch ist mit Vorteil die Herstellung von Halbleiterlasern in Großserie möglich. Vorzugsweise ist dabei jeweils an der dem Trägerkörper abgewandten Seite eines Vertikalemitters jeweils ein Pumplaser angeordnet.

Ein erfindungsgemäßes Verfahren zur Herstellung eines oberflächenemittierenden Halbleiterlasers umfasst insbesondere die folgenden Schritte:
- Bereitstellen eines Aufwachssubstrats;
- epitaktisches Aufwachsen einer ersten Halbleiterschichtenfolge, die einen Pumplaser umfasst;
- epitaktisches Aufwachsen einer zweiten Halbleiterschichtenfolge auf die erste Halbleiterschichtenfolge, wobei die zweite Halbleiterschichtenfolge einen Vertikalemitter umfasst, der mindestens eine aktive Zone aufweist;
- Freilegen von Bereichen des Pumplasers durch teilweises Tiefätzen der zweiten Halbleiterschichtenfolge, sodass die zweite Halbleiterschichtenfolge einen strahlungsemittierenden Bereich aufweist, der durch optisches Pumpen des Pumplasers im Betrieb Strahlung emittiert, und die erste und die zweite Halbleiterschichtenfolge mindestens einen Bereich aufweisen, der im Betrieb keine Strahlung emittiert.

Das Verfahren zeichnet sich vorteilhafterweise durch eine vereinfachte Prozessführung aus.

Bevorzugt wird vor dem Freilegen der Bereiche des Pumplasers ein Bragg-Spiegel auf die zweite Halbleiterschichtenfolge epitaktisch aufgewachsen. Alternativ kann nach dem epitaktischen Aufwachsen der zweiten Halbleiterschichtenfolge eine dielektrische Schichtfolge, die als Spiegel dient, auf die zweite Halbleiterschichtenfolge aufgebracht werden.

Bevorzugt werden die Bereiche des Pumplasers freigelegt, die zur Spiegelätzung und zum elektrischen Anschluss des Pumplasers benötigt werden.

Besonders bevorzugt werden zur Ausbildung eines Resonators Spiegel in dem Pumplaser mittels Spiegelätzung ausgebildet, wobei der Pumplaser durch Aufbringen einer ersten Kontaktschicht auf der dem Aufwachssubstrat abgewandten Seite des Pumplasers elektrisch angeschlossen wird.

Dadurch, dass lediglich die Bereiche der zweiten Halbleiterschichtenfolge entfernt werden, die für die nachfolgende Prozessierung, wie beispielsweise Spiegelätzung oder elektrischer Anschluss des Pumplasers, zugängig sein müssen, erhöht sich die mechanische Stabilität des Halbleiterlasers.

Vorzugsweise wird auf einer dem Pumplaser abgewandten Seite der zweiten Halbleiterschichtenfolge eine Lotschicht oder eine Klebeschicht aufgebracht. Mittels der Lotschicht oder der Klebeschicht wird an einer dem Pumplaser abgewandten Seite der zweiten Halbleiterschichtenfolge ein Trägerkörper befestigt. Alternativ wird der Trägerkörper mittels einer Thermo-Kompression befestigt.

Es erübrigt sich, wie herkömmlicherweise üblich, eine galvanische Schicht auf die zweite Halbleiterschichtenfolge aufzubringen. Dadurch reduzieren sich Verspannungen in dem Halbleiterlaser, die aufgrund der galvanischen Schicht entstehen können. Die Stabilität des Halbleiterlasers erhöht sich mit Vorteil.

Bevorzugt wird das Aufwachssubstrat entfernt.

Dadurch, dass der Vertikalemitter an einer der Strahlungsaustrittsseite gegenüberliegenden Seite an einem Trägerkörper befestigt wird, ist das Aufwachssubstrat für die mechanische Stabilität des Halbleiterlasers nicht mehr notwendig. Ferner unterliegt der Trägerkörper des Halbleiterlasers nicht den vergleichsweise hohen Anforderungen, die ein Aufwachssubstrat, etwa hinsichtlich der Kristallstruktur, erfüllen muss. Beispielsweise kann der Trägerkörper hinsichtlich thermischer Eigenschaften, wie beispielsweise einer hohen Wärmeleitfähigkeit, vergleichsweise frei gewählt werden. Dadurch verbessert sich mit Vorteil die Effizienz des Vertikalemitters.

Vorzugsweise wird eine Ätzstoppschicht vor Aufwachsen der ersten Halbleiterschichtenfolge auf das Aufwachssubstrat aufgebracht.

Die Ätzstoppschicht schützt mit Vorteil die erste Halbleiterschichtenfolge und somit den Pumplaser vor Schäden bei dem Prozess des Ablösens des Aufwachsubstrats. Dadurch vermindert sich beim Ablösen des Substrats die Gefahr, den Pumplaser zu beschädigen und so eine verminderte Effizienz der Pumpstrahlung zu erhalten.

Bevorzugt wird das Aufwachssubstrat entfernt und eine zweite Kontaktschicht zur elektrischen Kontaktierung des Pumplasers auf die Ätzstoppschicht auf der dem Pumplaser abgewandten Oberfläche strukturiert aufgebracht. Das Aufbringen der Ätzstoppschicht erfolgt beispielsweise mittels Lift-off-Technik.

Dadurch lässt sich bevorzugt in der zweiten Kontaktschicht eine Lichtaustrittsöffnung für die vom Vertikalemitter emittierte Strahlung realisieren, wodurch eine effiziente Auskopplung der von dem Vertikalemitter emittierten Strahlung erzielt wird.

Alternativ kann die zweite Kontaktschicht direkt auf die dem Vertikalemitter abgewandten Oberfläche des Pumlasers aufgebracht werden. Die zweite Kontaktschicht dient hierbei als Ätzstoppschicht, so dass eine zusätzliche Ätzstoppschicht zwischen Pumplaser und zweiter Kontaktschicht mit Vorteil nicht notwendig ist.

Bevorzugt werden mehrere Halbleiterlaser im Waferverbund, also auf einem gemeinsamen Trägerkörper oder Wafer, prozessiert. Dabei werden mehrere erste und zweite Halbleiterschichtenfolgen, und somit mehrere Pumplaser und Vertikalemitter, auf einem gemeinsamen Trägerkörper oder Wafer ausgebildet, wobei jeweils an der dem Trägerkörper abgewandten Oberfläche eines Vertikalemitters jeweils ein Pumplaser angeordnet ist. Die so auf einem gemeinsamen Trägerkörper ausgebildeten optoelektronischen Bauelemente können anschließend durch einen Ätzprozess, beispielsweise durch einen Mesa-Ätzprozess, separiert und demnach vereinzelt werden. Dadurch kann der Halbleiterlaser in Großserie hergestellt werden, wodurch sich Produktionszeit und Produktionskosten eines solchen oberflächenemittierenden Halbleiterlasers mit Vorteil reduzieren.

Der Trägerkörper enthält bevorzugt Ge, Molybdän oder Silizium.

Weitere Merkmale, Vorteile, bevorzugte Ausgestaltungen und Zweckmäßigkeiten des oberflächenemittierenden Halbleiterlasers ergeben sich aus den im Folgenden in Verbindung mit den Figuren 1 bis 3 erläuterten Ausführungsbeispielen. Es zeigen:
- Figur 1: einen schematischen Querschnitt eines ersten Ausführungsbeispiels eines erfindungsgemäßen Halbleiterlasers,
- Figur 2A-2E: Verfahrensschritte zum Herstellen eines erfindungsgemäßen Halbleiterlasers gemäß eines zweiten Ausführungsbeispiels,
- Figur 3: eine schematische Aufsicht auf einen oberflächenemittierenden Halbleiterlaser gemäß des zweiten Ausführungsbeispiels, und
- Figur 4: einen schematischen Querschnitt eines weiteren Ausführungsbeispiels eines erfindungsgemäßen Halbleiterlasers.

Gleiche oder gleich wirkende Bestandteile sind jeweils mit den gleichen Bezugszeichen versehen. Die dargestellten Bestandteile sowie die Größenverhältnisse der Bestandteile untereinander sind nicht als maßstabsgerecht anzusehen.

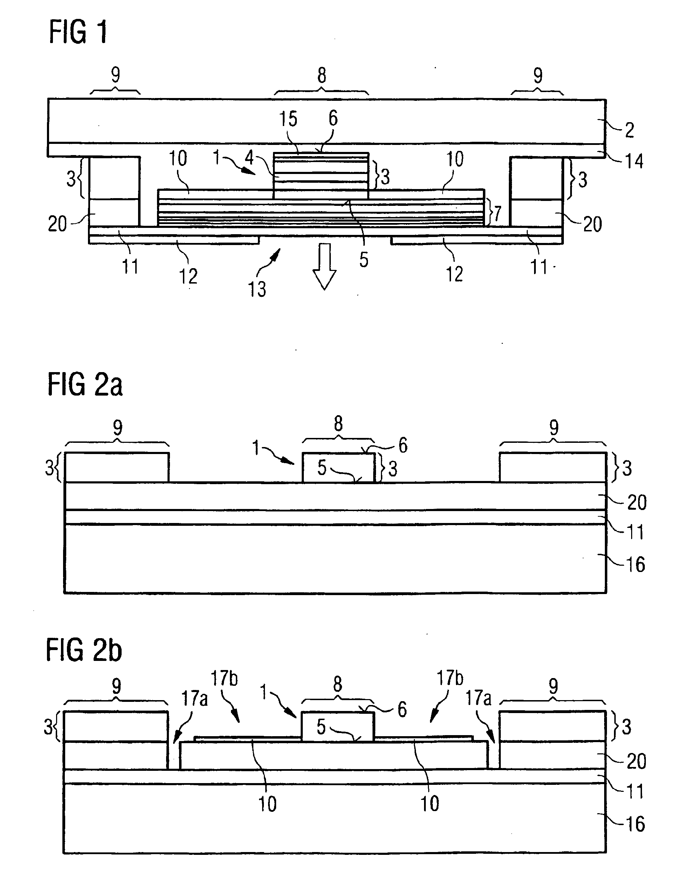

In Figur 1 ist ein schematischer Querschnitt eines erfindungsgemäßen Halbleiterlasers dargestellt. Der Halbleiterlaser ist vorzugsweise als Dünnfilm-Halbleiterlaser ausgeführt. Als Dünnfilm-Halbleiterlaser wird im Rahmen der Anmeldung ein Halbleiterlaser angesehen, während dessen Herstellung das Aufwachssubstrat, auf den eine erste Halbleiterschichtenfolge 20 und eine zweite Halbleiterschichtenfolge 3 beispielsweise epitaktisch aufgewachsen wurde, abgelöst worden ist.

Der Halbleiterlaser weist eine zweite Halbleiterschichtenfolge 3 auf, die einen Vertikalemitter 1 umfasst. Der Vertikalemitter 1 weist eine strahlungsemittierende aktive Schicht 4, eine Strahlungsaustrittsseite 5 und eine Befestigungsseite 6 auf. An der Strahlungsaustrittsseite 5 des Vertikalemitters 1 ist ein Pumplaser 7 angeordnet. An der Befestigungsseite 6 des Vertikalemitters 1 ist ein Trägerkörper 2 angeordnet. Die Auskopplung der von der aktiven Schicht 4 des Vertikalemitters 1 im Betrieb erzeugten Strahlung erfolgt durch den Pumplaser 7 hindurch. Die Auskopplung der von der aktiven Schicht 4 des Vertikalemitters 1 im Betrieb erzeugten Strahlung ist in Figur 1 durch einen Pfeil dargestellt.

Zur mechanischen Stabilisierung des Halbleiterlasers ist der Trägerkörper 2, der an der der Strahlungsaustrittsseite 5 gegenüberliegenden Seite des Vertikalemitters 1 angeordnet ist, vorgesehen. Es ist insbesondere kein Substrat auf der Strahlungsaustrittsseite 5 des Vertikalemitters 1 vorgesehen. Ferner findet eine galvanische Schicht, die beispielsweise Gold enthält und herkömmlicherweise auf den Vertikalemitter 1 aufgebracht ist, keine Verwendung. Verspannungen, die durch die galvanische Schicht auftreten können, treten somit nicht auf.

Der Trägerkörper 2 ist bevorzugt von dem Aufwachssubstrat für die erste und die zweite Halbleiterschichtenfolge verschieden. Somit unterliegt der Trägerkörper 2 des Halbleiterlasers mit Vorteil nicht den vergleichsweise hohen Anforderungen, die ein Aufwachssubstrat, etwa hinsichtlich der Kristallstruktur, erfüllen muss. Die Freiheitsgrade bei der Auswahl des Trägerkörpers 2 sind gegenüber den Freiheitsgraden bei der Auswahl des Aufwachssubstrats vorteilhaft erhöht. Beispielsweise kann der Trägerkörper 2 hinsichtlich thermischer Eigenschaften, wie einer hohen Wärmeleitfähigkeit, oder hinsichtlich des Ausdehnungskoeffizienten vergleichsweise frei gewählt werden. Wird die im Vertikalemitter 1 erzeugte Wärmemenge nicht ausreichend vom Vertikalemitter 1 abgeführt, so ist die Gefahr einer Leistungsminderung des Vertikalemitters 1 erhöht. Durch den Einsatz eines vom Aufwachssubstrat verschiedenen Trägerkörpers 2 mit bevorzugt hoher Wärmeleitfähigkeit kann diese Gefahr mit Vorteil verringert werden.

Dadurch, dass das Aufwachssubstrat abgelöst ist, ist es ferner nicht notwendig, eine Lichtaustrittsöffnung für die von dem Vertikalemitter 1 emittierte Strahlung in das Aufwachssubstrat zu ätzen. Eine vereinfachte Herstellung des Halbleiterlasers, und somit reduzierte Produktionskosten und eine reduzierte Produktionszeit des oberflächenemittierenden Halbleiterlasers sind mit Vorteil möglich.

Der Vertikalemitter 1 und der Pumplaser 7 basieren bevorzugt auf einem Arsenid-, einem Phosphit- oder einem Nitrid-Verbindungshalbleiter. Auf "Arsenid-, Phosphit- oder Nitrid-Verbindungsleiter basierend" bedeutet in diesem Zusammenhang, dass ein derart bezeichneter Halbleiterlaser oder Teil eines Halbleiterlasers vorzugsweise AlₙGaₘIn₁₋ₙ₋ₘAs, AlₙGaₘIn₁₋ₙ₋ₘP, oder AlₙGaₘIn₁₋ₙ₋ₘN umfasst, wobei 0 ≤ n ≤ 1, 0 ≤ m ≤ 1 und n + m ≤ 1. Dabei muss dieses Material nicht zwingend eine mathematisch exakte Zusammensetzung nach obiger Formel aufweisen. Vielmehr kann es einen oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, P, As, N), auch wenn diese teilweise durch geringe Mengen weiterer Stoffe ersetzt sein können.

Der Vertikalemitter 1 ist bevorzugt ein Halbleiterlaser, besonders bevorzugt ein Dünnfilm-Halbleiterlaser. Bevorzugt emittiert die aktive Schicht 4 des Vertikalemitters 1 infrarote Strahlung.

Die aktive Schicht 4 des Vertikalemitters 1 umfasst bevorzugt eine Mehrfachquantentopfstruktur (MQW) oder eine Einfachquantentopfstruktur (SQW) zur Strahlungserzeugung. Die Bezeichnung Quantentopfstruktur umfasst im Rahmen der Anmeldung insbesondere jegliche Struktur, bei der Ladungsträger durch Einschluss (confinement) eine Quantisierung ihrer Energiezustände erfahren können. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

Bevorzugt ist die aktive Schicht des Vertikalemitters 1 geeignet, die in dem Pumplaser 7 erzeugte elektromagnetische Strahlung zu absorbieren. Das heißt, eine Absorption von Pumpstrahlung erfolgt in der aktiven Schicht 4 des Vertikalemitters 1 und regt dort die Erzeugung von elektromagnetischer Strahlung an.

Der Vertikalemitter 1 ist auf Bereichen eines Pumplasers 7 angeordnet. Die aktive Schicht 4 des Vertikalemitters 1 ist hierbei an die Pumplaserstruktur optisch gekoppelt, sodass im Betrieb des Halbleiterlasers Pumpstrahlung von dem Pumplaser 7 in die aktive Schicht 4 des Vertikalemitters 1 geführt wird.

Die Wellenlänge der optischen Pumpstrahlung ist bevorzugt kleiner als die Wellenlänge der von der aktiven Schicht des Vertikalemitters 1 emittierten Strahlung. Der Pumplaser 7 weist einen Resonator für die Pumpstrahlung auf. Dazu sind zum Beispiel an zwei parallel zueinander liegenden Endflächen des Pumplasers 7 Spiegelflächen ausgebildet, die als Resonatorspiegel dienen. Die Pumplaserstruktur weist bevorzugt eine aktive Zone auf, die zwischen einer ersten und einer zweiten Wellenleiterschicht eingebettet ist, wobei die Wellenleiterschichten wiederum zwischen einer ersten und einer zweiten Mantelschicht eingebettet sind.

Die zweite Halbleiterschichtenfolge 3 weist bevorzugt einen strahlungsemittierenden Bereich 8 auf, der die strahlungsemittierende aktive Schicht 4 umfasst und durch optisches Pumpen des Pumplasers 7 im Betrieb Strahlung emittiert. Ferner weist die zweite Halbleiterschichtenfolge 3 mindestens einen Bereich 9 auf, der im Betrieb keine Strahlung emittiert.

Es wird also nicht, wie herkömmlicherweise, die gesamte zweite Halbleiterschichtenfolge 3 außerhalb des vorgesehenen strahlungsemittierenden Bereichs 8 entfernt, sondern es werden nur die Bereiche entfernt, bei denen bei nachfolgenden Prozessschritten ein Zugriff auf die erste Halbleiterschichtenfolge notwendig ist. Als nachfolgende Prozesse können beispielsweise Spiegelätzungen der Resonatorspiegel des Pumplasers 7 und/oder die elektrische Kontaktierung des Pumplasers 7 angesehen werden.

Ferner weist die erste Halbleiterschichtenfolge bevorzugt sowohl einen Bereich auf, der Pumpstrahlung erzeugt, als auch mindestens einen Bereich 9 auf, der im Betrieb des Halbleiterlasers keine Pumpstrahlung erzeugt.

Besonders bevorzugt sind auf den Bereichen 9 der ersten Halbleiterschichtenfolge 20, die im Betrieb keine Pumpstrahlung erzeugen, die Bereiche 9 der zweiten Halbleiterschichtenfolge 3 aufgebracht, die im Betrieb keine Strahlung emittieren.

Dadurch erhöht sich die Stabilität des Halbleiterlasers mit Vorteil, da sowohl die erste als auch die zweite Halbleiterschichtenfolge 3, 20 großflächig, nämlich bis auf die Bereiche, die für die nachfolgende Prozessierung zugängig sein müssen, ausgebildet sind.

Der Pumplaser 7 weist bevorzugt auf einer dem Vertikalemitter 1 zugewandten Oberfläche in Bereichen, auf denen die zweite Halbleiterschichtenfolge 3 entfernt ist, eine erste Kontaktschicht 10 auf. Die erste Kontaktschicht 10 dient zur elektrischen Kontaktierung des Pumplasers 7.

Auf der dem Vertikalemitter 1 abgewandten Oberfläche weist die erste Halbleiterschichtenfolge 20 bevorzugt eine Ätzstoppschicht 11 auf. Die Ätzstoppschicht 11 schützt den Pumplaser 7 vor Schäden, die bei dem Ablösen des Aufwachssubstrats entstehen können.

Die Ätzstoppschicht 11 weist auf einer dem Pumplaser 7 abgewandten Oberfläche bevorzugt eine zweite Kontaktschicht 12 auf, die in einem dem Vertikalemitter 1 gegenüberliegenden Bereich eine Aussparung 13 aufweist. Die zweite Kontaktschicht 12 und die erste Kontaktschicht 10 dienen zur gemeinsamen elektrischen Kontaktierung des Pumplasers 7. Die Aussparung 13 der Kontaktschicht 12 dient zur Strahlungsauskopplung der von der aktiven Schicht 4 des Vertikalemitters 1 emittierten Strahlung.

Alternativ kann lediglich eine zweite Kontaktschicht 12 auf der dem Vertikalemitter 1 gegenüberliegenden Oberfläche des Pumplasers 7 aufgebracht sein. In diesem Fall dient die zweite Kontaktschicht 12 zusätzlich als Ätzstoppschicht.

Die zweite Halbleiterschichtenfolge 3 ist beispielsweise mittels einer Lotschicht oder einer Klebeschicht 14 an dem Trägerkörper 2 befestigt. Alternativ kann die zweite Halbleiterschichtenfolge 3 mittels einer Thermo-Kompression an dem Trägerkörper 2 befestigt sein. Es ist nicht, wie herkömmlicherweise, notwendig, eine galvanische Schicht auf den Vertikalemitter 1 aufzubringen, der nachteilig zu Verspannungen in dem Halbleiterlaser führen kann, wodurch sich sowohl die Stabilität als auch die Lebensdauer des Halbleiterlasers mit Vorteil erhöht.

Bevorzugt weist der Vertikalemitter 1 auf der dem Pumplaser 7 abgewandten Seite einen Spiegel 15 auf. Der Spiegel 15 ist bevorzugt ein Bragg-Spiegel. Dadurch, dass der Spiegel 15 auf der dem Pumplaser 7 abgewandten Seite angeordnet ist, der Vertikalemitter 1 von dem Pumplaser 7 optisch gepumpt wird und somit eine elektrische Kontaktierung des Vertikalemitter 1 nicht notwendig ist, muss die Stromführung für den Pumplaser nicht über den Spiegel 15 erfolgen. Dadurch lassen sich Dotierungen im Spiegel 15 vermeiden, die zu einer verminderten Reflektivität des Spiegels 15 und somit zu optischen Verlusten der von dem Vertikalemitter 1 emittierten Strahlung führen. Insgesamt erniedrigt sich somit die Absorption der von dem Vertikalemitter 1 emittierten Strahlung in dem Spiegel 15.

Alternativ kann statt einem Bragg-Spiegel ein Spiegel 15, der sich aus einer dielektrischen Schichtfolge zusammensetzt, auf der dem Pumplaser 7 abgewandten Oberfläche des Vertikalemitters 1 aufgebracht sein.

Der Spiegel 15 bildet vorteilhaft einen ersten Resonatorspiegel des Vertikalemitters 1 aus. Ein zweiter Resonatorspiegel kann insbesondere als externer Resonatorspiegel außerhalb des Halbleiterchips angeordnet sein (nicht dargestellt). Der Halbleiterlaser ist also insbesondere ein oberflächenemittierender Halbleiterlaser mit externem Resonator (VECSEL).

Der Trägerkörper 2 enthält bevorzugt Ge, Molybdän oder Silizium, wodurch sich bevorzugt eine geeignete Wärmeableitung der von dem Vertikalemitter 1 abgegebenen Verlustwärme ermöglicht.

In den Figuren 2A bis 2E sind die Verfahrensschritte zum Herstellen eines erfindungsgemäßen Halbleiterlasers dargestellt.

In Figur 2A ist auf einem Aufwachssubstrat 16 eine erste Halbleiterschichtenfolge 20, die einen Pumplaser umfasst, epitaktisch aufgewachsen. Vor dem Aufwachsen der ersten Halbleiterschichtenfolge 20 wird vorzugsweise eine Ätzstoppschicht 11 aufgebracht. Die Ätzstoppschicht 11 dient dazu, dass bei einem späteren Prozessschritt des Ablösens des Aufwachssubstrats 16 der Pumplaser nicht beschädigt wird und so eine optimale Pumpstrahleffizienz im Betrieb des Halbleiterlasers erfolgen kann.

Auf den Pumplaser wird eine zweite Halbleiterschichtenfolge 3 aufgewachsen, die einen Vertikalemitter 1 umfasst. Die zweite Halbleiterschichtenfolge 3 weist einen Bereich 8 auf, der als strahlungsemittierender Bereich vorgesehen ist und eine strahlungsemittierende aktive Schicht 4 umfasst. Ferner weist die zweite Halbleiterschichtenfolge 3 Bereiche 9 auf, die nicht zur Strahlungsemittierung vorgesehen sind. Dazu wird die zweite Halbleiterschichtenfolge 3 in Bereichen um den vorgesehenen strahlungsemittierenden Bereich 8 herum tiefer geätzt.

Die tiefer geätzten Bereiche der zweiten Halbleiterschichtenfolge 3 ermöglichen bei dem nachfolgenden Prozessschritt, wie in Figur 2B dargestellt, einen Zugriff auf die benötigten Bereiche der ersten Halbleiterschichtenfolge 20. Als nachfolgende Prozessschritte sind beispielsweise das Ausbilden von Resonatorspiegel auf Seitenflächen 17a des Pumplasers 7 mittels Spiegelätzung vorgesehen. Ferner wird eine erste Kontaktschicht 10 auf dem Pumplaser 7 auf Bereiche 17b aufgebracht, auf denen keine zweite Halbleiterschichtenfolge 3 angeordnet ist.

Das Ausbilden der Resonatorspiegel in Bereichen 17a des Pumplasers 7 dient zur Ausbildung eines Resonators für die Pumpstrahlung des Pumplasers 7. Das Aufbringen der ersten Kontaktschicht 10 dient zur elektrischen Kontaktierung des Pumplasers 7.

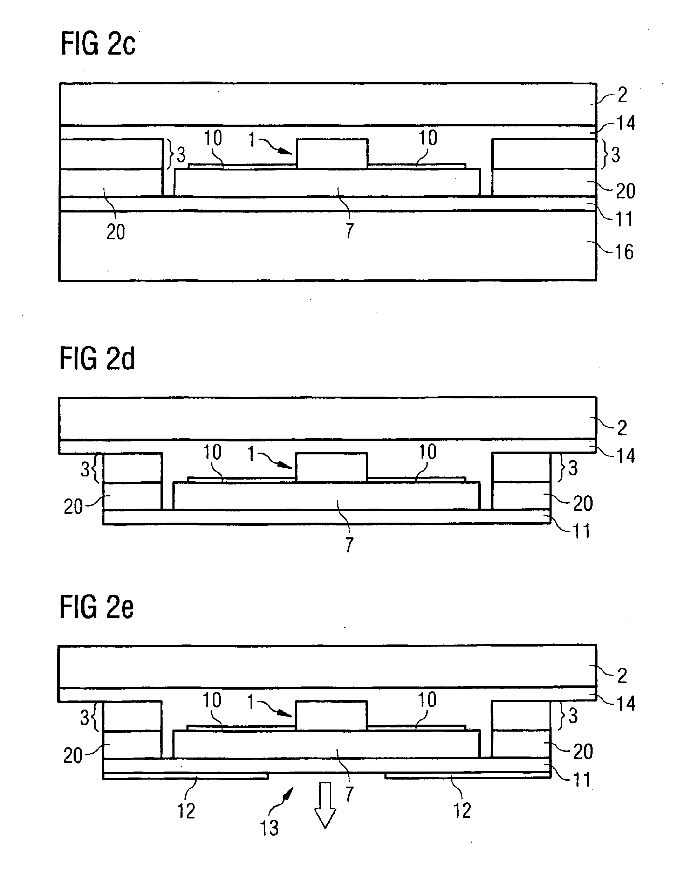

Nach der Spiegelätzung der Resonatorspiegel des Pumplasers 7 und nach dem elektrischen Anschluss des Pumplasers 7 wird, wie in Figur 2C dargestellt, mittels einer Lotschicht oder einer Klebeschicht 14 ein Trägerkörper 2 auf die zweite Halbleiterschichtenfolge 3 aufgebracht.

Eine galvanische Schicht, die beispielsweise Gold enthält, findet somit keine Verwendung. Dadurch treten Verspannungen im Halbleiterlaser, die durch die galvanische Schicht entstehen können, nicht auf. Die mechanische Stabilität des Halbleiterlasers erhöht sich durch die großflächig ausgebildete erste und zweite Halbleiterschichtenfolge mit Vorteil, wodurch sich ferner die Lebensdauer des Halbleiterlasers erhöht.

Anschließend wird, wie in Figur 2D dargestellt, das Aufwachssubstrat 16 abgelöst. Dabei schützt die Ätzstoppschicht 11 den Pumplaser 7 vor Schäden, die bei dem Ablösen des Aufwachssubstrats 16 entstehen können. Dadurch, dass die zweite Halbleiterschichtenfolge 3 an einem Trägerkörper 2 befestigt wird, ist das Aufwachssubstrat 16 für die Stabilität des Halbleiterlasers nicht mehr notwendig, und kann somit vollständig abgelöst werden.

Bei der Prozessierung mehrerer Halbleiterlaser im Waferverbund kann der Waferverbund während diesem Verfahrensschritt zu einzelnen Halbleiterlasern separiert werden. Die Trennung zu separierten Halbleiterlasern erfolgt vorzugsweise mittels Mesa-Ätzung.

Nachfolgend wird, wie in Figur 2E dargestellt, eine zweite Kontaktschicht 12 zur elektrischen Kontaktierung des Pumplasers 7 auf der dem Pumplaser 7 abgewandten Seite der Ätzstoppschicht 11, beispielsweise mittels Lift-off-Technik, strukturiert aufgebracht.

Dadurch lässt sich bevorzugt in der zweiten Kontaktschicht 12 eine Lichtaustrittsöffnung 13 für die vom Vertikalemitter 1 emittierte Strahlung realisieren, wodurch eine effiziente Auskopplung der von dem Vertikalemitter 1 emittierten Strahlung erzielt wird. Die Richtung der Strahlungsauskopplung ist in Figur 2E durch einen Pfeil dargestellt.

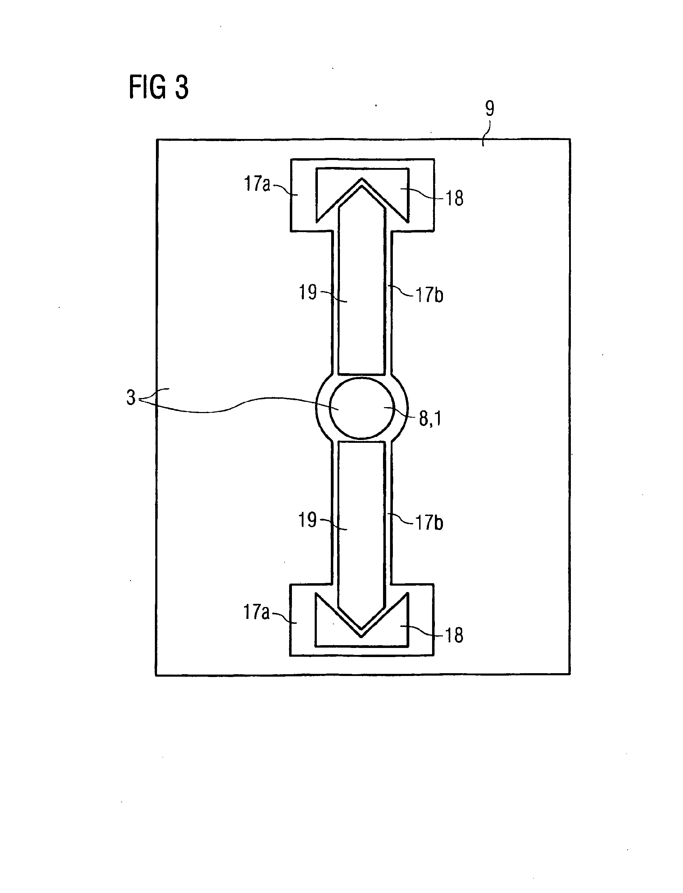

In Figur 3 ist eine schematische Aufsicht auf einen oberflächenemittierenden Halbleiterlaser dargestellt.

Die zweite Halbleiterschichtenfolge 3 weist einen strahlungsemittierenden Bereich 8 auf, der durch optisches Pumpen des Pumplasers im Betrieb des Halbleiterlasers Strahlung emittiert (Vertikalemitter 1). Ferner weist die zweite Halbleiterschichtenfolge 3 einen Bereich 9 auf, der im Betrieb keine Strahlung emittiert.

Der strahlungsemittierende Bereich 8 der zweiten Halbleiterschichtenfolge 3 ist auf einem Pumplaser angeordnet. Der Pumplaser weist einen Resonator 19 für die Pumpstrahlung auf. An zwei gegenüberliegenden Seiten des Resonators 19 sind Resonatorspiegel 18 ausgebildet.

In Bereichen 17a, 17b ist die zweite Halbleiterschichtenfolge 3 durch einen Ätzprozess entfernt, um während der Herstellung des Halbleiterlasers einen Zugriff auf die erste Halbleiterschichtenfolge in diesen Bereichen zu ermöglichen. Dabei sind die Bereiche 17a zur Ausbildung der Resonatorspiegel 18 vorgesehen. Die Bereiche 17b sind zum elektrischen Anschluss des Pumplasers vorgesehen. Alle anderen Bereiche der zweiten Halbleiterschichtenfolge 3 werden nicht entfernt und bilden einen Bereich 9 aus, der im Betrieb keine Strahlung emittiert.

Durch eine solche Anordnung erhöht sich die Stabilität des Halbleiterlasers, da eine großflächig ausgebildete zweite Halbleiterschichtenfolge 3 vorgesehen ist. Ferner vereinfacht sich der Herstellungsprozess, da lediglich die Bereiche der zweiten Halbleiterschichtenfolge 3 entfernt werden, die zur Herstellung zur ersten Halbleiterschichtenfolge zugänglich sein müssen. Die Produktionskosten und die Produktionszeit reduzieren sich mit Vorteil.

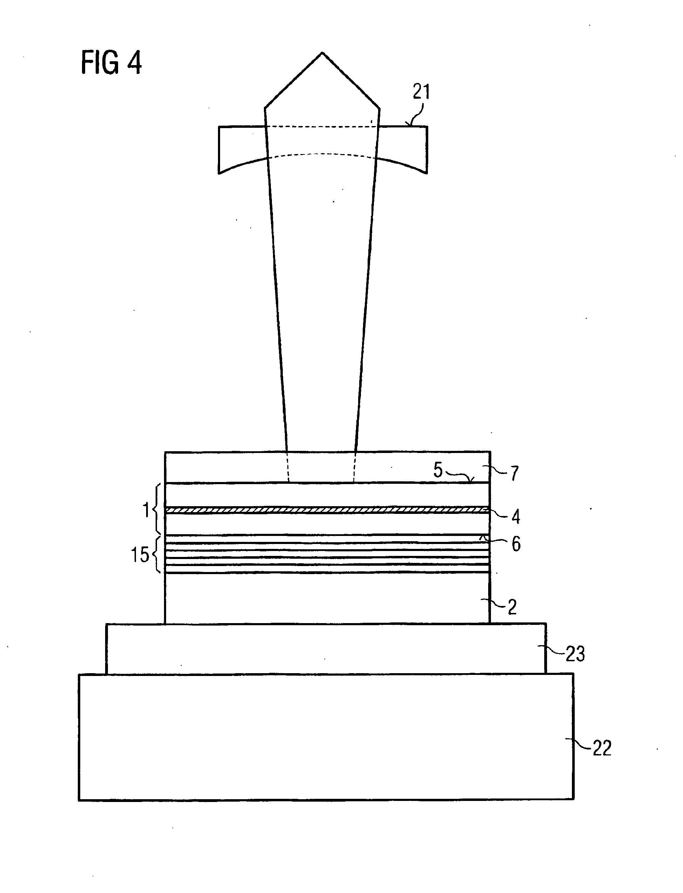

In Figur 4 ist ein Querschnitt eines nicht erfindungsgemäßen Halbleiterlasers, insbesonders ein Vertikalemitter, dargestellt.

Der Vertikalemitter 1 ist vorzugsweise als Dünnfilm-Vertikalemitter ausgeführt und weist eine strahlungsemittierende aktive Schicht 4, eine Strahlungsaustrittsseite 5 und eine Befestigungsseite 6 auf. An der Befestigungsseite 6 des Vertikalemitters 1 ist ein Trägerkörper 2 zur Stabilisierung des Vertikalemitters 1 angeordnet, der von einem Aufwachssubstrat der Halbleiterschichtenfolge des Vertikalemitters 1 verschieden ist.

Bevorzugt weist der Vertikalemitter 1 auf der dem Trägerkörper 2 zugewandten Seite einen Spiegel 15 auf. Der Spiegel 15 ist bevorzugt ein Bragg-Spiegel.

Der Spiegel 15 bildet vorteilhaft einen ersten Resonatorspiegel des Vertikalemitters 1 aus. Ein zweiter Resonatorspiegel 21 kann insbesondere als externer Resonatorspiegel außerhalb des Halbleiterlasers angeordnet sein. Der Halbleiterlaser ist also insbesondere ein oberflächenemittierender Halbleiterlaser mit externem Resonator (VECSEL).

Der Trägerkörper 2 enthält bevorzugt Ge, Molybdän oder Silizium, wodurch sich bevorzugt eine geeignete Wärmeableitung der von dem Vertikalemitter 1 abgegebenen Verlustwärme ermöglicht.

Für eine verbesserte Wärmeableitung kann eine Wärmesenke 22 auf der von dem Vertikalemitter 1 abgewandten Seite des Trägerkörpers 2 angeordnet sein. Die Wärmesenke 22 ist bevorzugt mittels einer Lotschicht oder einer Klebeschicht 23 an dem Trägerkörper 2 befestigt.

An der Strahlungsaustrittsseite 5 des Vertikalemitters 1 ist ein Pumplaser 7 angeordnet.

Alternativ ist ein Pumplaser zum optischen Pumpen der aktiven Schicht 4 des Vertikalemitters denkbar, bei dem der Pumplaser eine kantenemittierende Halbleiterstruktur aufweist (nicht dargestellt). In diesem Fall ist der kantenemittierende Pumplaser derart angeordnet, daß die Pumpstrahlung aus seitlicher Richtung in die aktive Schicht 4 des Vertikalemitters 7 eingestrahlt wird. Insbesondere sind die aktive Schicht 4 des Vertikalemitters 1 und der Pumplaser vorzugsweise derart lateral nebeneinander angeordnet, dass die aktive Zone des Pumplasers und die aktive Schicht 4 des Vertikalemitters 1 auf gleicher Höhe liegen. Insbesondere sind in diesem Fall der Pumplaser und der Vertikalemitter 1 auf einem gemeinsamen Trägerkörper 2 angeordnet.

Ferner ist denkbar, dass die aktive Schicht 4 des Vertikalemitters im Betrieb des Halbleiterlasers mittels eines externen Pumplasers gepumpt wird (nicht dargestellt).

Die Erläuterung des erfindungsgemäßen Halbleiterlasers anhand der oben beschriebenen Ausführungsbeispiele ist nicht als Beschränkung der Erfindung auf diese zu betrachten. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder den Ausführungsbeispielen angegeben ist.

## Patentansprüche

1. Oberflächenemittierender Halbleiterlaser, umfassend:
- eine erste Halbleiterschichtenfolge (20), die einen Pumplaser (7) umfasst,
- eine auf der ersten Halbleiterschichtenfolge (20) angeordnete zweite Halbleiterschichtenfolge (3), die einen Vertikalemitter (1) umfasst, der eine strahlungsemittierenden aktive Schicht (4), eine Strahlungsaustrittsseite (5) und eine der Strahlungsaustrittsseite (5) gegenüberliegende Befestigungsseite (6) aufweist, wobei der Pumplaser (7) an der Strahlungsaustrittsseite (5) des Vertikalemitters (1) angeordnet ist, und
- einen Trägerkörper (2), der an der Befestigungsseite (6) des Vertikalemitters (1) auf der zweiten Halbleiterschichtenfolge (3) befestigt ist,
- **dadurch gekennzeichnet, dass**
- die zweite Halbleiterschichtenfolge (3) durch teilweises Tiefätzen in einen strahlungsemittierenden Bereich (8), der durch optisches Pumpen durch den Pumplaser im Betrieb Strahlung emittiert, und in mindestens einen Bereich (9), der im Betrieb keine Strahlung emittiert, aufgeteilt wird, wobei
- die zweite Halbleiterschichtenfolge (3) in Bereichen um den strahlungsemittierenden Bereich (8) herum tiefer geätzt ist als im strahlungsemittierenden Bereich (8) und im Bereich (9), der im Betrieb keine Strahlung emittiert.

2. Oberflächenemittierender Halbleiterlaser gemäß Anspruch 1, wobei
die erste Halbleiterschichtenfolge (20) einen Bereich aufweist, der Pumpstrahlung erzeugt, und mindestens einen Bereich (9), der im Betrieb keine Pumpstrahlung erzeugt.

3. Oberflächenemittierender Halbleiterlaser gemäß Anspruch 2, wobei
auf dem mindestens einen Bereich (9) der ersten Halbleiterschichtenfolge (20), der im Betrieb keine Pumpstrahlung erzeugt, der mindestens eine Bereich (9) der zweiten Halbleiterschichtenfolge (3) angeordnet ist, der im Betrieb keine Strahlung emittiert.

4. Oberflächenemittierender Halbleiterlaser gemäß einem der vorhergehenden Ansprüche, wobei
der Pumplaser (7) auf einer dem Vertikalemitter (1) zugewandten Seite auf Bereichen, auf denen keine zweite Halbleiterschichtenfolge (3) aufgebracht ist, eine erste Kontaktschicht (10) aufweist.

5. Oberflächenemittierender Halbleiterlaser gemäß einem der vorhergehenden Ansprüche, wobei
die erste Halbleiterschichtenfolge (20) auf einer dem Vertikalemitter (1) abgewandten Seite eine Ätzstoppschicht (11) aufweist.

6. Oberflächenemittierender Halbleiterlaser gemäß Anspruch 5, wobei
eine zweite Kontaktschicht (12) zur elektrischen Kontaktierung des Pumplasers (7) auf eine von dem Pumplaser (7) abgewandten Oberfläche der Ätzstoppschicht (11) aufgebracht ist, die in einem dem Vertikalemitter (1) gegenüberliegenden Bereich eine Aussparung (13) aufweist.

7. Oberflächenemittierender Halbleiterlaser gemäß einem der vorhergehenden Ansprüche, wobei
die zweite Halbleiterschichtenfolge (3) an dem Trägerkörper (2) befestigt ist.

8. Oberflächenemittierender Halbleiterlaser gemäß einem der vorhergehenden Ansprüche, wobei
der Vertikalemitter (1) auf der dem Pumplaser (7) abgewandten Seite einen Bragg-Spiegel (15) aufweist.

9. Oberflächenemittierender Halbleiterlaser gemäß einem der vorhergehenden Ansprüche, wobei
ein Aufwachssubstrat (16), auf dem die erste und die zweite Halbleiterschichtenfolge (20, 3) aufgewachsen wurden, abgelöst ist.

10. Oberflächenemittierender Halbleiterlaser gemäß einem der vorhergehenden Ansprüche, wobei
der Trägerkörper (2) von einem Aufwachssubstrat (16) für die erste und die zweite Halbleiterschichtenfolge (20, 3) verschieden ist.

11. Verfahren zur Herstellung eines oberflächenemittierenden Halbleiterlasers, umfassend die Schritte:
- Bereitstellen eines Aufwachssubstrats (16),
- epitaktisches Aufwachsen einer ersten Halbleiterschichtenfolge (20), die einen Pumplaser (7) umfasst,
- epitaktisches Aufwachsen einer zweiten Halbleiterschichtenfolge (3) auf die erste Halbleiterschichtenfolge (20), wobei die zweite Halbleiterschichtenfolge (3) einen Vertikalemitter umfasst, der mindestens eine aktive Zone (4) aufweist,
- Freilegen von Bereichen des Pumplasers (7) durch teilweises Tiefätzen der zweiten Halbleiterschichtenfolge (3), wobei die zweite Halbleiterschichtenfolge (3) in Bereichen um einen vorgesehenen strahlungsemittierenden Bereich (8) herum tiefer geätzt wird, so dass die zweite Halbleiterschichtenfolge (3) durch das genannte Tiefätzen in einen strahlungsemittierenden Bereich (8), der durch optisches Pumpen durch den Pumplaser (7) im Betrieb Strahlung emittiert, und in mindestens einen Bereich (9), der im Betrieb keine Strahlung emittiert, aufgeteilt wird, und
- Befestigen eines Trägerkörpers (2) auf der zweiten Halbleiterschichtenfolge (3).

12. Verfahren gemäß Anspruch 11, wobei
zur Ausbildung eines Resonators (19) Spiegel (18) in dem Pumplaser (7) mittels Spiegelätzung ausgebildet werden und der Pumplaser (7) durch Aufbringen einer ersten Kontaktschicht (10) auf der dem Aufwachssubstrat (16) abgewandten Seite des Pumplasers (7) elektrisch angeschlossen wird.

13. Verfahren gemäß einem der Ansprüche 11 oder 12, wobei auf einer dem Pumplaser abgewandten Seite der zweiten Halbleiterschichtenfolge (3) eine Lotschicht (14) aufgebracht wird und die zweite Halbleiterschichtenfolge (3) an einer dem Pumplaser (7) abgewandten Seite mittels der Lotschicht (14) am Trägerkörper (2) befestigt wird.

14. Verfahren gemäß einem der Ansprüche 11 bis 13, wobei das Aufwachssubstrat (16) entfernt wird.

15. Verfahren gemäß einem der Ansprüche 11 bis 14, wobei eine Ätzstoppschicht (11) vor Aufwachsen der ersten Halbleiterschichtenfolge (20) auf das Aufwachssubstrat (16) aufgebracht wird.

## Claims

1. Surface emitting semiconductor laser, comprising:
- a first semiconductor layer sequence (20), which comprises a pump laser (7),
- a second semiconductor layer sequence (3), which is arranged on the first semiconductor layer sequence (20) and which comprises a vertical emitter (1) having a radiation-emitting active layer (4), a radiation exit side (5) and a fixing side (6) lying opposite the radiation exit side (5), wherein the pump laser (7) is arranged at the radiation exit side (5) of the vertical emitter (1), and
- a carrier body (2), which is fixed on the second semiconductor layer sequence (3) at the fixing side (6) of the vertical emitter (1),
**characterized in that**:
- the second semiconductor layer sequence (3) is divided by partial deep etching into a radiation-emitting region (8) which emits radiation during operation as a result of optical pumping by the pump laser, and into at least one region (9) which does not emit radiation during operation, wherein
- the second semiconductor layer sequence (3) is etched more deeply in regions around the radiation-emitting region (8) than in the radiation-emitting region (8) and in the region (9) which does not emit radiation during operation.

2. Surface emitting semiconductor laser according to Claim 1, wherein
the first semiconductor layer sequence (20) has a region which generates pump radiation and at least one region (9) which does not generate pump radiation during operation.

3. Surface emitting semiconductor laser according to Claim 2, wherein
the at least one region (9) of the second semiconductor layer sequence (3) which does not emit radiation during operation is arranged on the at least one region (9) of the first semiconductor layer sequence (20) which does not generate pump radiation during operation.

4. Surface emitting semiconductor laser according to any of the preceding claims, wherein
the pump laser (7) has a first contact layer (10) on a side facing the vertical emitter (1), on regions on which no second semiconductor layer sequence (3) is applied.

5. Surface emitting semiconductor laser according to any of the preceding claims, wherein
the first semiconductor layer sequence (20) has an etching stop layer (11) on a side remote from the vertical emitter (1).

6. Surface emitting semiconductor laser according to Claim 5, wherein
a second contact layer (12) for making electrical contact with the pump laser (7) is applied to a surface of the etching stop layer (11) which is remote from the pump laser (7), said second contact layer having a cutout (13) in a region lying opposite the vertical emitter (1).

7. Surface emitting semiconductor laser according to any of the preceding claims, wherein
the second semiconductor layer sequence (3) is fixed to the carrier body (2).

8. Surface emitting semiconductor laser according to any of the preceding claims, wherein
the vertical emitter (1) has a Bragg mirror (15) on the side remote from the pump laser (7).

9. Surface emitting semiconductor laser according to any of the preceding claims, wherein
a growth substrate (16), on which the first and the second semiconductor layer sequences (20, 3) were grown, is stripped away.

10. Surface emitting semiconductor laser according to any of the preceding claims, wherein
the carrier body (2) is different than a growth substrate (16) for the first and the second semiconductor layer sequences (20, 3).

11. Method for producing a surface emitting semiconductor laser, comprising the following steps:
- providing a growth substrate (16),
- epitaxially growing a first semiconductor layer sequence (20), which comprises a pump laser (7),
- epitaxially growing a second semiconductor layer sequence (3) onto the first semiconductor layer sequence (20), wherein the second semiconductor layer sequence (3) comprises a vertical emitter (1) having at least one active zone (4),
- uncovering regions of the pump laser (7) by partial deep etching of the second semiconductor layer sequence (3), wherein the second semiconductor layer sequence (3) is etched more deeply in regions around a radiation-emitting region (8) provided, such that the second semiconductor layer sequence (3) is divided by said deep etching into a radiation-emitting region (8) which emits radiation during operation as a result of optical pumping by the pump laser (7), and into at least one region (9) which does not emit radiation during operation,
- fixing a carrier body (2) on the second semiconductor layer sequence (3).

12. Method according to Claim 11, wherein
in order to form a resonator (19), mirrors (18) are formed in the pump laser (7) by means of mirror etching and the pump laser (7) is electrically connected by application of a first contact layer (10) on that side of the pump laser (7) which is remote from the growth substrate (16).

13. Method according to either of Claims 11 and 12, wherein a solder layer (14) is applied on a side of the second semiconductor layer sequence (3) which is remote from the pump laser and the second semiconductor layer sequence (3) is fixed to the carrier body (2) by means of the solder layer (14) at a side remote from the pump laser (7).

14. Method according to any of Claims 11 to 13, wherein
the growth substrate (16) is removed.

15. Method according to any of Claims 11 to 14, wherein an etching stop layer (11) is applied to the growth substrate (16) prior to the growth of the first semiconductor layer sequence (20).

## Revendications

1. Laser à semi-conducteur et émission de surface comprenant :
une première succession (20) de couches semi-conductrices qui comprend un laser de pompage (7),
une deuxième succession (3) de couches semi-conductrices disposée sur la première succession (20) de couches semi-conductrices, qui comprend un émetteur vertical (1) doté d'une couche (4) active en émission de rayonnement,
un côté (5) de sortie de rayonnement et un côté de fixation (6) opposé au côté (5) de sortie de rayonnement, le laser pompé (7) étant disposé sur le côté (5) de sortie de rayonnement de l'émetteur vertical (1), et
un corps de support (2) fixé sur le côté de fixation (6) de l'émetteur vertical (1) de la deuxième succession (3) de couches semi-conductrices,
**caractérisé en ce que**
la deuxième succession (3) de couches semi-conductrices est divisée par gravure profonde partielle en une partie (8) émettant un rayonnement qui émet en fonctionnement un rayonnement par pompage optique du laser de pompage et en au moins une partie (9) qui n'émet pas de rayonnement en fonctionnement,
la deuxième succession (3) de couches semi-conductrices est gravée plus profondément autour des parties qui entourent la partie (8) émettant un rayonnement que dans la partie (8) émettant un rayonnement et que dans la partie (9) qui n'émet pas de rayonnement en fonctionnement.

2. Laser à semi-conducteur et émission de surface selon la revendication 1, dans lequel la première succession (20) de couches semi-conductrices présente une partie qui forme un rayonnement de pompage et au moins une partie (9) qui en fonctionnement ne forme pas de rayonnement de pompage.

3. Laser à semi-conducteur et émission de surface selon la revendication 2, dans lequel la ou les parties (9) de la deuxième succession (3) de couches semi-conductrices qui n'émettent pas de rayonnement en fonctionnement sont disposées sur la ou les parties (9) de la première succession (20) de couches semi-conductrices qui ne forment pas de rayonnement de pompage en fonctionnement.

4. Laser à semi-conducteur et émission de surface selon l'une des revendications précédentes, dans lequel le laser de pompage (7) présente une première couche de contact (10) sur des parties sur lesquelles aucune deuxième succession (3) de couches semi-conductrices n'est placée sur le côté tourné vers l'émetteur vertical (1).

5. Laser à semi-conducteur et émission de surface selon l'une des revendications précédentes, dans lequel la première succession (20) de couches semi-conductrices présente une couche (11) d'arrêt de gravure sur un côté non tourné vers l'émetteur vertical (1).

6. Laser à semi-conducteur et émission de surface selon la revendication 5, dans lequel une deuxième couche de contact (12) qui assure le contact électrique du laser de pompage (7) est appliquée sur une surface de la couche (11) d'arrêt de gravure non tournée vers le laser de pompage (7) et présente une découpe (13) dans une partie située face à l'émetteur vertical (1).

7. Laser à semi-conducteur et émission de surface selon l'une des revendications précédentes, dans lequel la deuxième succession (3) de couches semi-conductrices est fixée sur le corps de support (2).

8. Laser à semi-conducteur et émission de surface selon l'une des revendications précédentes, dans lequel l'émetteur vertical (1) présente un miroir de Bragg (15) sur le côté non tourné vers le laser de pompage (7).

9. Laser à semi-conducteur et émission de surface selon l'une des revendications précédentes, dans lequel un substrat de croissance (16) sur lequel la première succession et la deuxième succession (20, 3) de couches semi-conductrices ont crû est dissous.

10. Laser à semi-conducteur et émission de surface selon l'une des revendications précédentes, dans lequel les corps de support (2) sont différents sur un substrat de croissance (16) prévu pour la première et pour la deuxième succession (20, 3) de couches semi-conductrices.

11. Procédé de fabrication d'un laser semi-conducteur à émission de surface, le procédé comportant les étapes qui consistent à :
préparer un substrat de croissance (16),
faire croître par épitaxie une première succession (20) de couches semi-conductrices qui comporte un laser de pompage (7),
faire croître par épitaxie une deuxième succession (3) de couches semi-conductrices sur la première succession (20) de couches semi-conductrices, la deuxième succession (3) de couches semi-conductrices comportant un émetteur vertical (1) qui présente au moins une zone active (4),
libérer des parties du laser de pompage (7) par gravure profonde partielle de la deuxième succession (3) de couches semi-conductrices, la deuxième succession (3) de couches semi-conductrices étant gravée plus profondément par les parties qui entourent une partie (8) prévue pour émettre un rayonnement, de telle sorte que la deuxième succession (3) de couches semi-conductrices soit divisée par ladite gravure profonde en une partie (8) émettant un rayonnement qui émet en fonctionnement un rayonnement par pompage optique par le laser de pompage (7) et en au moins une partie (9) qui n'émet pas de rayonnement en fonctionnement, et
fixer un corps de support (2) sur la deuxième succession (3) de couches semi-conductrices.

12. Procédé selon la revendication 11, dans lequel pour former un résonateur (19), des miroirs (18) sont formés par gravure à miroir dans le laser de pompage (7) et le laser de pompage (7) est raccordé électriquement par une première couche de contact (10) disposée sur le côté du laser de pompage (7) non tourné vers le substrat de croissance (16).

13. Procédé selon l'une des revendications 11 ou 12, dans lequel une couche de brasure (14) est appliquée sur un côté de la deuxième succession (3) de couches semi-conductrices non tourné vers le laser de pompage et la deuxième succession (3) de couches semi-conductrices est fixée sur le corps de support (2) au moyen de la couche de brasure (14) sur un côté non tourné vers le laser de pompage (7).

14. Procédé selon l'une des revendications 11 à 13, dans lequel le substrat de croissance (16) est enlevé.

15. Procédé selon l'une des revendications 11 à 14, dans lequel une couche (11) d'arrêt de gravure est appliquée sur le substrat de croissance (16) avant la croissance de la première succession (20) de couches semi-conductrices.
